(19) Europäisches Patentamt
European Patent Office
Office européen des brevets

(11) Publication number: **0 007 747**
**B1**

(12) **EUROPEAN PATENT SPECIFICATION**

(45) Date of publication of patent specification: **01.09.82**

(51) Int. Cl.³: **C 09 D 3/00, C 08 L 51/00, C 08 F 283/00**

(21) Application number: **79301371.5**

(22) Date of filing: **12.07.79**

(54) **Radiation-curable coating compositions and method of coating metal substrates therewith.**

(30) Priority: **13.07.78 US 924263**
**11.08.78 US 933010**

(43) Date of publication of application:
**06.02.80 Bulletin 80/3**

(45) Publication of the grant of the patent:
**01.09.82 Bulletin 82/35**

(84) Designated Contracting States:
**BE CH DE FR GB IT NL SE**

(56) References cited:
**FR - A - 2 311 804**

(73) Proprietor: **Rohm and Haas Company**
**Independence Mall West**
**Philadelphia, Pennsylvania 19105 (US)**

(72) Inventor: **Emmons, William David**
**1411 Holcomb Road**
**Huntingdon Valley, Pennsylvania, 19006 (US)**

(74) Representative: **Angell, David Whilton et al,**
**Rohm and Haas Company Patent Department**
**Chesterfield House Barter Street**
**London WC1A 2TP (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 007 747 B1

Radiation-curable coating compositions and method of coating metal substrates therewith

This invention is concerned with radiation-curable coating compositions comprising certain monomer, oligomer and a particular acid and a method of coating metal substrates with such a composition.

In solvent-based coatings which are applied to a substrate a solution of permanently thermoplastic vinyl copolymer in non-reactive solvent, which evaporates at the time of application, it has been usual practice to include in the mixture of monomers that is used to make the copolymer small amounts of an acid monomer, such as maleic acid or acrylic acid. U.S.—A—3,037,955, such as example 1, discloses that improvement in adhesion to bare metals is obtained when various free acids are added to the solution of the vinyl copolymer in small amounts of 0.5 to 3% by weight. U.S.—A—3,266,930 discloses the copolymerization of various vinyl and acrylic monomers with 0.5 to 10% by weight of an acid of the formula

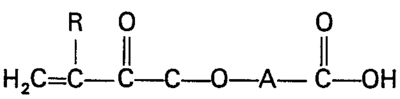

Wherein R is H or $CH_3$ and A is an alkylene group having 1 to 3 carbon atoms. The resulting copolymer is dissolved in a solvent, applied to a substrate, and dried and cured by a conventional baking operation to develop adhesion to metal substrates.

U.S.—A—3,300,547 discloses anaerobic adhesive sealant compositions comprising acrylate ester monomers, a hydroperoxide catalyst, and certain adhesion imparting materials (polymers, especially polyester resins, e.g., 80/20 styrene/acrylate polymer, having a molecular weight between 2,000 and 40,000). The compositions may also contain an adhesion promoter "characterized by the presence of a polymerizable terminal double bond or ethylenic linkage adjacent a polar functional group of the compound", or a mixture of such promoters. Among the adhesion promoting materials, the patent mentions the following acids and their anhydrides: crotonic, itaconic, nadic, methylnadic, acrylic, methacrylic and maleic.

U.S.—A—4,048,259 discloses the addition of an easter-acid of the formula:

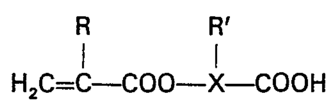

in which R is H or $CH_3$, R′ is H, halogen, —COOH, —CN, or a ($C_1$—$C_8$) alkyl group and X is a hydrocarbon group of 1 to 6 carbon atoms, to an anaerobic adhesive comprising a polymerizable acrylic ester and an organic peroxide polymerization initiator to improve the adhesion to metals, such as steel. This patent in col. 2 lines 12 to 17, acknowledges U.S.—A—3,300,547 with the comment "However, carboxyl substituents have a corrosive action toward steel".

100% solids polymerizable radiation-curable coatings are increasingly penetrating the metal finishing industry, especially in the metal decorating and can coating area. They are non-polluting and require markedly less energy for cure than conventional solvent based baking systems. However, virtually all radiation cured coatings based on vinyl unsaturation (primarily acrylic) suffer from poorer adhesion than baked coatings. It is generally agreed that a major factor contributing to poor adhesion is internal stress created by the rapid shrinkage on polymerization. With a baked coating, oven temperature is usually above the glass temperature allowing internal mobility for stress relaxation and conformance to the microstructure of the substrate. The post-baking of a radiation cured coating has been tried (U.S.—A—3,856,744) and it generally improves adhesion.

In U.S.—A—3,912,670, radiation-curable coating compositions are provided which contain a radiation curable oil, a flow control additive and at least 20% by weight of acrylic acid as reactive solvent, with or without other reactive solvent. The use of at least 20% by weight of acrylic acid in the composition is stated to give unexpectedly high adhesion to metals, especially to untreated aluminium. However, acrylic acid is quite volatile, has a strong acrid odour (like vinegar) and is a strong acid, highly corrosive to steel at these use levels.

In U.S.—A—4,052,280, a UV sensitizer is incorporated into the backbone of a UV-curable ethylenically unsaturated polymer in a particular spaced relationship away from the ethylenic unsaturation, thereby improving adhesion to the substrate on radiation curing.

The reaction product of a hydroxyalkyl acrylate with a cyclic anhydride has been suggested as an adhesion-promoter in radiation-curable coatings (B. Trathnigg and J. Wendrinsky, *Farbe and Lack,* 82(2), 100 (1976).

In U.S.—A—3,943,103, the dissolution of a low molecular weight vinyl acetate polymer is a radiation-curable composition containing a polyfunctional reactive compound containing at least two radiation-curable polymerizable >C=C< groups and optionally a monofunctional reactive compound

having one such group is claimed to improve adhesion to metals.

Finally, it may be mentioned that radiation curable compositions based on isobornyl acrylate, a low molecular weight oligomer or polymer and a photoinitiator are disclosed in FR—A—2 311 804.

We have now found that the adhesion of certain radiation-curable compositions to substrates, especially bare metals such as aluminium, steel, copper and zinc, can be enhanced by the incorporation of a small amount of 3-acryloxypropionic acid of the formula:

$$H_2C{=}CH{-}C(O)O{-}CH_2CH_2{-}C(O)OH$$

This acid is referred to herein as AOPA and is also known as $\beta$-acryloxypropionic acid.

Compared with acrylic acid, as used in U.S.—A—3,912,670 in an amount of at least 20% by weight of the radiation-curable composition, AOPA is far less volatile and suffers lower loss during curing. Because lower levels of AOPA can be used and it is a weaker acid than acrylic there is less corrosive effect on bare metal surfaces such as steel. AOPA is also better than acrylic acid from an environmental standpoint since it has a far milder odour. Yet, when AOPA is used, better adhesion is generally attainable with a smaller amount. AOPA also provides cost and performance advantages over its methacrylic analogue in the compositions of the invention. AOPA is more readily available, cheaper to produce, less toxic and more reactive.

According to the invention there is provided a radiation curable coating composition which comprises:

(a) at least one ethylenically unsaturated monomer selected from 2-ethylhexyl acrylate, isobornyl acrylate, ethoxyethoxyethyl acrylate, dicyclopentenyloxyethyl acrylate and dicyclopentenyloxyethyl methacrylate.

(b) at least one acrylated oligomeric condensation or addition product having at least two, terminal or pendant acryloxy groups of the formula: $H_2C{=}C(R)COO{-}$ where R is H or $CH_3$, and

(c) from 1 to 15% preferably 2 to 8%, by weight, based on the total weight of (a) and (b) of 3-acryloxypropionic acid and, optionally,

(d) a photosensitizer and/or an amine accelerator.

Generally, monomer component (a) is present in an amount of from 10 to 90 parts by weight and oligomer component (b) from 90 to 10 parts by weight, based on the combined weights of (a) and (b). The oligomeric component has, by definition, a relatively low molecular weight, preferably from 600 to 20000 weight average.

The radiation curable compositions of this invention may be compositions containing the specified components as a film-forming binder or those components may form a radiation curable composition suitable for use in a radiation curable composition containing other components conventional in the art. It is preferred that the compositions of the invention be 100% solids compositions for the environmental and economic reasons mentioned above. It is also preferred that the compositions contain components selected only from those listed above. The AOPA is reactive and forms part of the cured product. It can therefore be considered to form part of the reactive monomer content of the composition.

Component (b) is preferably a radiation-curable acrylated condensation polymer having at least two acryloxycapped groups. Examples of such radiation-curable condensation polymers include the following:

A) Urethane (meth) acrylates obtained by reacting isocyanate groups of a polyisocyanate, such as hexamethylene diisocyanate with a hydroxyalkyl (meth) acrylate, e.g. hydroxyethyl acrylate. These polyurethane poly (meth) acrylate monomers are disclosed in U.S.—A—3,297,745.

B) Polyether (meth) acrylates obtained by esterification of hydroxy-terminated polyethers with acrylic or methacrylic acid as disclosed in U.S.—A—3,380,831.

C) Polyesters having at least two (meth) acrylate groups obtained by esterifying hydroxyl groups with (meth) acrylic acid as disclosed in U.S.—A—3,935,173.

D) Polyfunctional (meth) acrylates disclosed in U.S.—A—3,560,237, e.g. obtained by reaction of a hydroxyalkyl (meth) acrylate, e.g. hydroxyethyl acrylate, with any of:
 a) Dicarboxylic acids having from 4 to 15 carbon atoms,
 b) Polyepoxides having terminal glycidyl groups,
 c) Polyisocyanates having terminal reactive isocyanate groups.

E) (Meth) acrylate-terminated polyesters made from (meth) acrylate acid, a polyol having at least three hydroxyl groups, and a dicarboxylic acid (U.S.—A—3,567,494).

F) Poly (meth) acrylates obtained by the reaction of (meth) acrylic acid with at least two epoxy groups of epoxidized drying oils, such as soybean oil, linseed oil, and the like e.g. epoxidized corresponding drying oil fatty acid, an ester or amide thereof, or the corresponding alcohol, containing at least two epoxy groups. Such polyfunctional (meth) acrylates are disclosed in U.S.—A—3,125,592.

G) Poly (meth) acrylates which are urethane or amine derivatives of the poly (meth) acrylated epoxidized drying oils, fatty acids and the like described in F) and U.S. Patent mentioned therein, obtained by the reaction of isocyanate(s) or amine(s) respectively with the poly (meth) acrylated epoxidized drying oils, fatty acids, and the like described in U.S.—A—3,125,592. The urethane and amine derivatives regain some or all of the (meth) acrylate groups and are disclosed in U.S.—A—3,876,518 and U.S.—A—3,878,077.

H) Poly (meth) acrylates obtained by reaction of (meth) acrylic acid by addition to the epoxy groups of aromatic bisphenol-based epoxy resins as disclosed in U.S.—A—3,373,075.

I) Poly (meth) acrylates obtained by the addition of (meth) acrylic acid to a linear vinyl polymer having pendant glycidyl groups, e.g. polymers of glycidyl (meth) acrylate or of vinyl glycidyl ether or vinyl glycidyl sulfide as disclosed in U.S.—A—3,530,100.

J) Polyfunctional (meth) acrylates derived from (meth) acrylic acid anhydride and polyepoxides as disclosed in U.S.—A—3,676,398.

K) Polyfunctional (meth) acrylate urethane esters obtained from the combining of hydroxyalkyl (meth) acrylates, a diisocyanate, and a hydroxyl functional alkyd condensate as disclosed in U.S.—A—3,673,140.

L) (Meth) acrylate terminated urethane polyesters obtained by reaction of a polycaprolactone diol or triol with an organic polyisocyanate, e.g., a diisocyanate, and a hydroxyalkyl (meth) acrylate. Such products are disclosed in U.S.—A—3,700,643.

M) Urethane poly (meth) acrylates obtained by reaction of a hydroxyl-containing ester of a polyol with (meth) acrylic acid and a polyisocyanate, such as those described in U.S.—A—3,759,809.

Preferred are C), D)c), and H).

Preferred polyfunctional unsaturated compounds of the "complex" type above for use in the coating compositions are the acrylic acid adducts to polyepoxides in which the epoxy group is attached to adjacent carbon atoms, that is the epoxy group is a vic-epoxy group. The polvepoxide may be any epoxidized vegetable or animal oil having ten or more carbon atoms in the fatty acid component and sufficient unsaturation to provide at least two epoxy groups in the epoxidized oil. Drying oils or semi-drying oils such as linseed oil or soybean oil are especially useful for epoxidation and subsequent acrylation. The polyepoxide to be acrylated may be any resin-forming polyepoxide having at least two terminal groups of the formula,

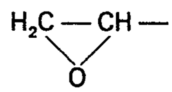

obtainable by reacting epichlorohydrin and a polyhydroxy phenol or an aliphatic diol or polyol, e.g. bisphenol A, glycerol, glycol, diethylene glycol, hexamethylene glycol and the like. Low molecular weight vinyl addition copolymers or glycidyl vinyl ether and of glycidyl (meth) acrylate may also be acrylated to form acrylated polyepoxides.

Preferably component (b) comprises an acrylated epoxidized soybean oil or a poly acrylate or methacrylate obtained by the reaction of acrylic or methacrylic acid by addition to the epoxy groups of a bisphenol-based epoxy resin.

Polymers A) to M) above may be more particularly described by the following extracts from the respective patents: U.S.—A—3,297,745.

The monomers are prepared by reacting an organic diisocyanate such as toluene diisocyanate

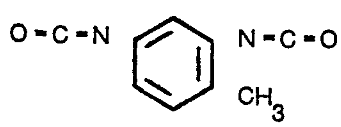

with an ethylenically unsaturated alcohol having the empirical formula

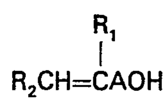

wherein:

$R_1$ is selected from the class consisting of $—H$ and $—CH_3$;
$R_2$ is selected from the class consisting of $—H$; $—CH_3$; and $—C_6H_5$; and
A is a divalent organic radical selected from the class consisting of

$—CH_2—$ ; 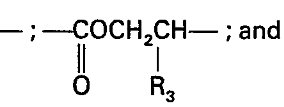 ; and 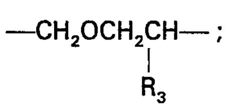 ;

wherein

$R_3$ is selected from the class consisting of

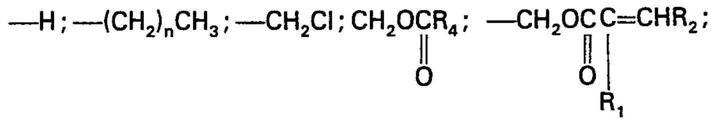

$—CH_2OR_4—$ and $—CH_2OCH_2CH{=}CHR_2$

wherein:

n is an integer from zero to ten; and

$R_4$ is selected from the class consisting of phenyl and halogenated phenyl radicals, alkyl and halogenated alkyl radicals having from one to two carbon atoms, benzoxy, phenoxy and halogenated benzoxy and phenoxy radicals.

For each mol of the diisocyanate, two mols of the ethylenically unsaturated alcohol are utilized. The reactants are mixed and heated to a temperature above ambient room temperature, preferably below about 200°C. Usually the exothermic heat of reaction will be sufficient to complete the reaction. Where the reactants are solids, a suitable inert solvent may be employed such as benzene, toluene, xylene. The reactants are maintained at a reaction temperature until substantial completion of the reaction is indicated by a reduction of the —N=C=O content to substantially zero.

The resulting monomer contains two urethane linkages and at least two ethylenically unsaturated carbon-to-carbon linkages:

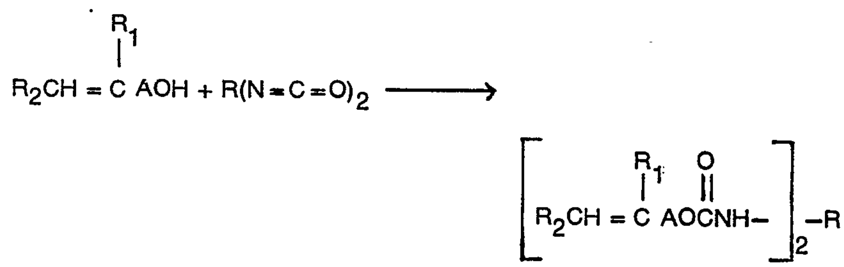

wherein R is a divalent organic radical. In the preferred monomers, the ethylenically unsaturated linkages are terminal groups

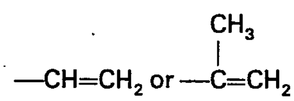

yielding divinyl monomers, i.e., the $R_2$ radical is hydrogen. Where the ethylenically unsaturated alcohol contains two ethylenically unsaturated carbon-to-carbon linkages, the resulting monomer will contain four ethylenically unsaturated linkages.

U.S.—A—3,380,831

Branched chain polyol polyether polyesters of alpha-methylene carboxylic acids of 3—4 carbons contain the three radicals represented by the formula

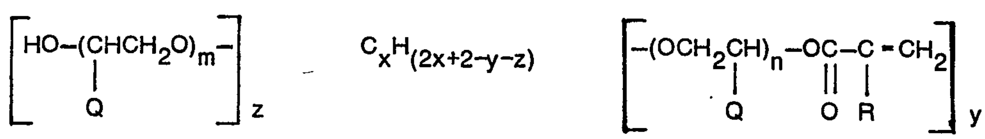

free hydroxyl chain end — polyhydric alcohol carbon skeleton — alkylene oxide chain extender — addition polymerizable ester chain end

wherein:

Q is H, $CH_3$ or $C_2H_5$,

R is H or $CH_3$,

x is 3, 4, 5 or 6 and is equal to or greater than y+z,

y is 2, 3, 4, 5 or 6,

z is 0, 1, 2, 3 or 4 and y+z is greater than 2,

m is 0, 1 or more, and

n is 1 or more.

The polyhydric alcohol skeleton may be derived from such compounds as trimethylolpropane, glycerol, the penitols, e.g., pentaerythritol; and the hexitols, e.g., d-mannitol and d-sorbitol. Other polyfunctional compounds capable of reaction with alkylene oxides may be used. Ethylene oxide and propylene oxide may be used as chain extenders and also as chain terminators containing free hydroxyl groups. Acrylic acid and methacrylic acid are suitable alpha-methylene carboxylic acids for providing addition polymerizable ester chain ends.

U.S.—A—3,935,173

Oligo(meth)acrylates having a (meth)acroyl group equivalent of not more than 1000 and being prepared by esterifying (1) a polyhydric alcohol, (2) a polycarboxylic compound selected from the group consisting of a polycarboxylic acid and the anhydride thereof, said polyhydric alcohol and polycarboxylic compound not being a dihydric alcohol and dicarboxylic compound respectively at the same time, and (3) (meth)acrylic acid to produce the oligo(meth)acrylate and polyol poly(meth)acrylates prepared by esterifying a polyhydric alcohol and (meth)acrylic acid to produce the polyol poly(meth)acrylate.

U.S.—A—3,560,237

Vinyl ester resins made by reacting:

(1) A polyfunctional material selected from the group consisting of (a) dicarboxylic acids having from 4 to 15 carbon atoms, (b) polyepoxides having terminal, reactive glycidyl groups or (c) polyfunctional isocyanates having terminal, reactive isocyanate groups, with

(2) 2-hydroxylalkyl acrylates or methacrylates.

U.S.—A—3,567,494

Polymerizable ester prepared by the co-condensation of acrylic acid and a dicarboxylic acid selected from alpha-unsaturated, alpha, beta-dicarboxylic acids having 4 to 5 carbon atoms, and saturated aliphatic dicarboxylic acids having 3 to 12 carbon atoms with a polyhydric alcohol having at least 3 esterifiable hydroxyl groups on adjacent carbon atoms, 45% to 95% of the hydroxyl groups being esterified with the acrylic acid, and 5% to 55% of the hydroxyl groups being esterified with the dicarboxylic acid.

U.S.—A—3,125,592

Polymerizable vinylated monomer which comprises reacting an epoxidized ester of an alcohol and a higher aliphatic carboxylic acid with a vinyl aliphatic monocarboxylic acid of the formula

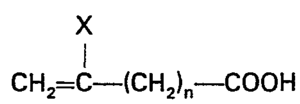

wherein n is an integer ranging from 0 to 2 and X is a group selected from the class consisting of hydrogen, lower alkyl, phenyl, benzyl, halogen, cyano and $—CH_2—COO$ (alkyl) in the presence of phenolic free radical inhibitor and of gaseous oxygen, said inhibitor and oxygen cooperating to inhibit vinyl polymerization, said higher aliphatic carboxylic acid having a chain of 10—24 carbon atoms, whereby said epoxidized ester is acylated with the carboxyl group of said vinyl acid at an oxirane segment

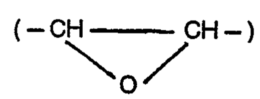

Preparation of the vinylated long chain compounds is typified by the reaction of one mol of acrylic acid with one mol of the 2-ethylhexyl ester of 9,10-epoxystearic acid according to the following equation:

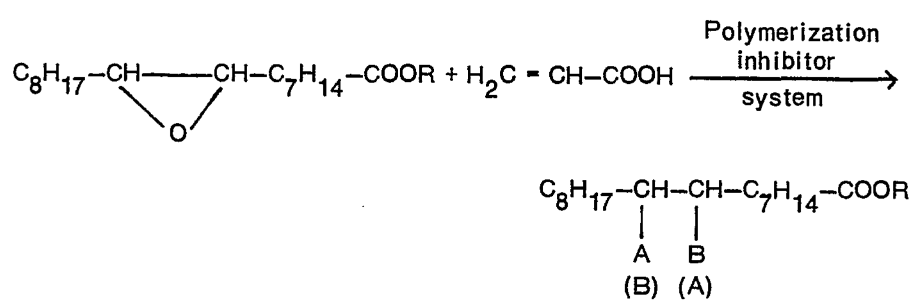


where A is hydroxy, B is acryloxy, and R is 2-ethylhexyl. A mixture of the 2-ethylhexyl esters of 9-acryloxy-10- hydroxystearic acid and 9-hydroxy-10-acryloxystearic acid is obtained because the carbon-oxygen bonds in the oxirane ring are opened singly and randomly by the carboxyl group of the acrylic acid.

U.S.—A—3,876,518 and U.S.—A—3,878,077

In the reaction of the acrylated epoxidized soybean oil compound with an amine compound, the

amine compound is preferably a secondary amine of the formula $R_2'NH$, wherein each R' can be substituted or unsubstituted alkyl having from 1 to about 15 carbon atoms, or an aryl group having up to 15 carbon atoms, (or an aryl group having up to 15 carbons), or the $R_2'$ unit together with the nitrogen atom of the NH group forms a ring structure having 5 or 6 ring atoms. Illustrative thereof one can mention dimethylamine, diethylamine, dibutylamine, dioctylamine, di-2-ethylhexylamine, diphenylamine, N-methyl-N-phenylamine, morpholine, piperidine, pyrrolidine, and the like. In this reaction the amine compound adds across the double bone of the acrylyl unit of the acrylated epoxidized soybean oil compound to produce a compound containing the group

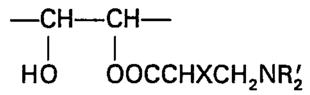

The urethane derivatives of the acrylated epoxidized soybean oil and the amine derivatives of the acrylated epoxidized soybean oil are preferred.

Thus, the urethane derivatives of the acrylated epoxidized soybean oil contain the group

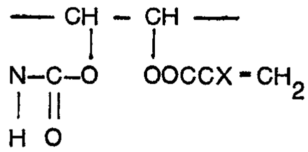

U.S.—A—3,373,075

The formula

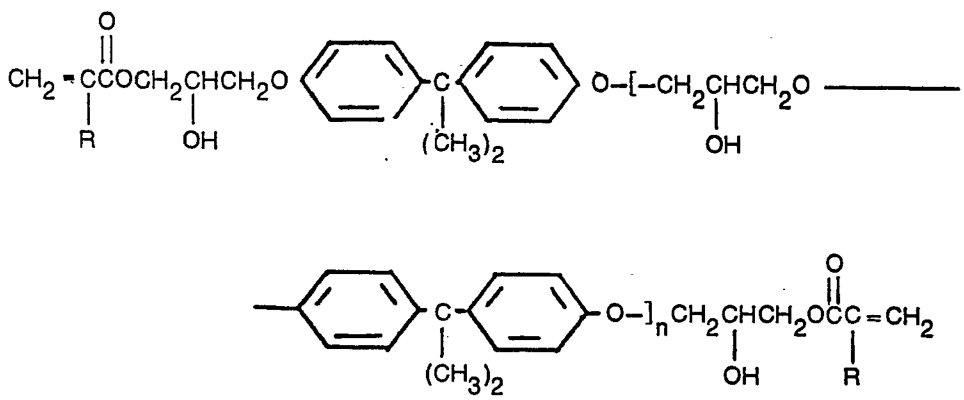

wherein R is a substituent selected from the class consisting of hydrogen, methyl and ethyl radicals and n is an integer from zero to twenty, represents diacrylates which are preferably prepared by reaction of a diglycidyl ether or polyglycidyl ethers of Bisphenol A with two mols of a carboxylic acid selected from the class consisting of acrylic, methacrylic and ethacrylic acids.

U.S.—A—3,530,100

The polymers disclosed in this patent have a plurality of repeating units of the formula

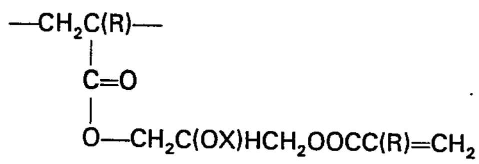

wherein

R is hydrogen, methyl, chloro or cyano and

X is hydrogen, an acyl radical or a urethane radical.

U.S.—A—3,676,398

The reaction product of a polyepoxide containing at least two epoxy groups,

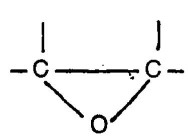

in its structure with an acryloyl carboxylic acid anhydride of the formula

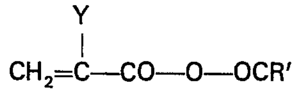

The reaction of the epoxy groups in the polyepoxides with these anhydrides yields the diester derivatives,

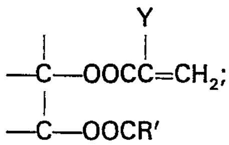
(A)

Accordingly, the monomeric reaction product contains at least two groups represented by structure (A), in which Y represents H, $CH_3$, Cl, Br, and CN; R′ represents H, a group which is essentially hydrocarbon containing one to 20 carbon atoms, and a halogenated derivative of the said hydrocarbon group.

U.S.—A—3,673,140

The reaction product of

1. an alkyd formed from trimethylol propane, tall oil fatty acid, and adipic acid with
2. the reaction product of toluene diisocyanate and the monoacrylic acid ester of ethylene glycol.

U.S.—A—3,700,643

Unsaturated acrylate-capped polycaprolactone polyol derivatives are produced having terminal acrylyl groups and at least one polycaprolactone polyol chain residue in the molecule. In one of its simplest forms the final product can be the reaction product of a polycaprolactone diol an organic isocyanate and hydroxyethyl acrylate.

U.S.—A—3,759,809.

The product of the reaction of (a) a polyfunctional polyethylenically unsaturated monomeric ester having free hydroxyl groups and formed by the reaction of an ethylenically unsaturated acid and a polyhydric alcohol with (b) an organic isocyanate, the isocyanate-modified ester product having a hydroxyl number of about 15 to 70.

The compositions may also contain a photosensitizer (or photoinitiator), particularly when curing is by exposure to ultraviolet or visible radiation. Examples include selected acyloins or derivatives thereof, for example, benzoin alkyl ethers, such as benzoin methyl ether and benzoin ethyl ether, desyl halides, such as desyl bromide and desyl chloride, desyl amine, benzophenone derivatives, acetophenone compounds, polychlorinated aromatic compounds, combination of organic carbonyl and amines or mixtures thereof. The acetophenone photoinitiators are disclosed in U.S.—A—3,715,293. The combination of organic carbonyls and amines is disclosed in U.S.—A—3,759,807. The proportion of photosensitizer and amine accelerator, when used, may be from 0.1 to 5 weight % of the composition. Any of the organic carbonyl photosensitizers and any of the amine activators listed in U.S.—A—3,759,807 may be used together.

The invention also provides a method of coating a metal substrate which comprises applying to the substrate a composition according to the invention and curing the composition by exposure to radiation. Preferably the radiation has a wavelength of from $2000 \times 10^{-10}$ m to $5000 \times 10^{-10}$ m or more is supplied by an electron beam.

The compositions of the invention may be applied to a substrate such as metal in any suitable way, such as by brushing, roll-coating or spraying. The substrate may then be passed through a zone of radiation to effect curing of the coating layer, which generally is adequately accomplished in a period of 1 to 30 seconds depending on the intensity of the source of radiation and its closeness to the coating. The light radiation may be ultraviolet light generated by a low, medium, or high pressure mercury lamp. Curing may be effected by exposing the composition to electromagnetic radiation having a wave length of 200 to 800 nanometers or to accelerated electron beams having energy of 100 keV to 500 keV at a total dose of 0.1 to 100 Mrads. When such alternative (to ultraviolet) radiation sources are used, the use of a photosensitizer in the coating composition is not required. Any of the light sources described in U.S.—A—3,759,807 may be used for curing the coated substrates.

Some preferred embodiments of the invention will now be more particularly described in and by the following examples in which all parts and percentages are by weight unless otherwise stated. In the examples the substrates are coded as follows:

| Code | Definition |
|---|---|
| UA | Untreated aluminum: Type A bare alloy 3003 H14, Federal Test Std. No. 141, Method 2013; 0.635 mm (from Q—Panel Company). |
| AA | Alodined aluminum: Type AL above treated with Alodine 1200S chrome oxide, MIL—C—5541. (Q—Panel Company). |
| SS | Smooth steel: Cold Rolled Steel, SAE 1010 Low Carbon, Type QD, 0.508 mm, smoothness 8—12 mu; ASTM D609.3B, Fed. Test std. No. 141, Method 2011 (Q—Panel Company). |
| MS | Matte steel: as above but Type R, 0.813 mm, smoothness 35—50 mu; ASTM D609.2B, same Fed. Test Std. (Q—Panel Company). |
| BS | Bonderite Steel: Cold Rolled Steel, 24 Gauge with Bonderite 1000 Iron Phosphate Coating (Parker Company). |
| GS | Ground Steel: Cold Rolled Steel, SAE 1010 Low Carbon; Type S 0.813 mm, smoothness 15—25 m; ASTM D609.2B, Fed. Test Std. No. 141, Method 2011 (Q—Panel Company). |

Various components of the coating are coded as follows:

| Code | Component a) Reactive Diluent Monomers |
|---|---|
| M1 | isobomyl acrylate |
| M2 | 2-ethylhexyl acrylate |
| M3 | ethoxyethoxyethyl acrylate |
| M4 | dicyclopentenyloxyethyl acrylate |
| M5 | dicyclopentenyloxyethyl methacrylate |

| Code | Components d) and e) Photoinitiator Components* |
|---|---|
| DEAP | $\alpha,\alpha$-diethoxyacetophenone |
| BP | Benzophenone |
| MDEA | methyl diethanol amine |

*See U.S.—A—3,715,293 and U.S.—A—3,801,329

| Code | Component c) Acrylate Functional Oligomers |
|---|---|
| A | A polyfunctional acrylated epoxidized soybean oil with an oil-like character. It is a clear yellow liquid of specific gravity 1.069 40/20°C, pour point 35°C, viscosity of 18,600/2,800/700 cps (18.6/2.8/0.7 Pas). at 40°/60°/80°C respectively, and has an acrylate content of 2.8 milli-equivalents per gram (available as Ucar Actomer X—80, Union Carbide). |
| B | The diacrylate ester of a liquid bisphenol A epoxy resin having a viscosity of about 9,000 poise (900 Pas) at 250°C and a density of about 83.5 $kgdm^{-3}$ (available as Epocryl Resin DRH—370, Shell Chemical Co.). |
| C | An acrylate functional polyurethane based resin having a viscosity of about 30,000 (30 Pas) cps. at 50°C, a specific gravity of 1.08, and an unsaturation of 1.2 milliequivalents per gram (available as Castomer U—0100, Witco Chemical Co.). |
| D | An acrylate functional polyurethane, the condensate of a polyol, a diisocyanate, and a hydroxy alkyl acrylate. It is supplied as a 67% solution in 2-ethoxyethyl acrylate with a viscosity of 1.8—2.2 (0.18—0.22 Pas) poises and a density of 75.9 kg $dm^{-3}$ (available as Uvimer 775, polychrome Corp). |
| E | A vinyl modified unsaturated polyester resin. The polyester resin is the condensate of maleic anhydride and ethoxylated bisphenol A terminated with vinyl groups attached by urethane linkages (available as Atlac 580, ICI United States). |

Coating Sample Preparation

In all of the examples, the coating ingredients as given in parts by weight were mixed until clear and homogeneous. The coatings were applied with a number 30 wire-wound rod to yield about 38.1 $\mu$m film thickness, and were cured in air with an Ashdee Company 25H Laboratory UV Curing Unit at a distance of 152.4 mm under two 200 W/25.4 mm. Hanovia medium pressure mercury lamps for 4 passes at a conveyor speed of 9.14 m $min^{-1}$.

Adhesion Testing

Tape crosshatch adhesion test was performed according to ANSI/ASTM D3395—76, Method B(11 cuts). Adhesion values given as percent of coating remaining in test grid.

Examples 1—17

These examples (See test results in Table I) demonstrate the adhesion promoting characteristics of AOPA in compositions applied to a variety of metal substrates. The test formulations contain 40 parts by weight of oligomer A with 60 parts by weight of the diluent specified in the table. Two parts by weight of DEAP was used in all of the examples in Table I but it was supplemented by 0.8 part by weight of BP in examples 1 and 2. The entry in the third column under the heading AOPA specifies the amount of AOPA added in parts by weight.

Untreated aluminum is especially difficult to adhere to, yet good results can be achieved with proper selection of reactive diluent, e.g., M1 and M5.

TABLE 1

| | | | Adhesion to Substrate | | | | | |
|---|---|---|---|---|---|---|---|---|
| Ex. | Diluent | AOPA | UA | AA | SS | MS | GS | BS |
| 1 | M5 | 0 | 50 | 100 | 20 | 80 | 80 | 90 |
| 2 | M5 | 2 | 100 | 100 | 100 | 100 | 100 | >95 |
| 3 | M1 | 0 | 25 | 0 | <10 | 20 | 30 | 10 |
| 4 | M1 | 2 | 75 | <10 | 100 | 100 | 100 | 80 |
| 5 | M1 | 8 | >95 | 100 | | | | |
| 6 | M1 | 15 | >95 | 100 | | | | |
| 7 | M4 | 0 | 0 | <10 | 0 | | | <10 |
| 8 | M4 | 2 | 10 | 35 | 15 | | | 40 |
| 9 | M4 | 4 | 0 | 50 | 0 | | | 40 |
| 10 | M4 | 8 | 10 | 100 | 30 | | | 70 |
| 11 | M2 | 0 | 0 | <10 | 0 | | | 75 |
| 12 | M2 | 2 | 10 | 80 | <10 | | | 80 |
| 13 | M2 | 8 | 20 | 100 | 35 | | | 90 |
| 14 | M3 | 0 | 0 | 0 | 0 | | | 0 |
| 15 | M3 | 2 | 0 | 30 | <10 | | | 20 |
| 16 | M3 | 4 | <10 | 80 | 15 | | | 45 |
| 17 | M3 | 8 | 0 | 30 | 20 | | | 100 |

*Substrates were cleaned by wiping with toluene-wet paper towels prior to application of coatings.

Examples 18—21

In these examples, the formulations all contain 40 parts of oligomer B, 60 parts of a 50/50 weight ratio mixture of diluents M3 and M4, 2 parts of DEAP and the amount of AOPA given in Table II.

TABLE II

| | | Adhesion to Substrate* | | |
|---|---|---|---|---|
| Ex. | AOPA | AA | SS | MS |
| 18 | 0 | 10 | 0 | 0 |
| 19 | 2 | 60 | 0 | 45 |
| 20 | 4 | 50 | 0 | 35 |
| 21 | 8 | 50 | 10 | 90 |

*Substrates used as received

Examples 22—25

In these examples, the formulations have the compositions shown in table III with 2 parts by weight of DEAP added in such example.

TABLE III

| | Coating Composition Parts by weight | | | Adhesion to Substrate* | | |
|---|---|---|---|---|---|---|
| Ex. | Oligomer | Diluent | AOPA | UA | AA | SS |
| 22 | 60C | 40 M1 | 0 | 5 | 100 | <10 |
| 23 | 60C | 40 M1 | 2 | 35 | 100 | 25 |
| 24 | 70D | 30 M1 | 0 | 0 | 25 | 0 |
| 25 | 70D | 30 M1 | 2 | 75 | 100 | 100 |

*Substrates cleaned by wiping with toluene-wet paper towel prior to application of coatings.

Examples 26—29

The formulations used in these examples correspond to those used in Examples 7 through 10 inclusive except that 40 parts of oligomer E is used instead of 40 parts of oligomer A. Table IV lists the results of these tests.

TABLE IV

| | | Adhesion to Substrate* | | | |
|---|---|---|---|---|---|
| Ex. | AOPA | UA | AA | SS | MS |
| 26 | 0 | 0 | 0 | 0 | 15 |
| 27 | 2 | 0 | 95 | 0 | 95 |
| 28 | 4 | 0 | 95 | 0 | 95 |
| 29 | 8 | 85 | 95 | 95 | 95 |

*Substrates used as received.

The applicant acknowledges the following trade marks which may or may not be registered in some or all of the designated states:

Bonderite

Ucar

Epocryl

Castomer

Uvimer

Atlac

## Claims

1. A radiation-curable coating composition for metal substrates comprising a mixture of:

(A) from 10—90 parts by weight, based on the combined weights of (A) and (B) of at least one acrylate or methacrylate ester selected from the following: isobornyl acrylate, 2-ethylhexyl acrylate, ethoxyethoxyethyl acrylate, dicyclopentenyloxyethyl acrylate and dicyclopentenyloxyethyl methacrylate;

(B) from 10—90 parts by weight, based on the combined weights of (A) and (B) of at least one acrylated oligomeric condensation or addition product which contains at least two acryloxy groups of the formula $H_2C{=}C(R)COO—$ where R is H or $CH_3$; and

(C) optionally a photosensitizer and/or amine accelerator; characterised in that the composition additionally contains:

(D) from 1—15% by weight, based on the combined weight of components (A) and (B), of 3-acryloxypropionic acid.

2. A composition according to claim 1 which is a 100% solids composition consisting of components (A), (B), (D) and optionally (C).

3. A composition according to claim 1 or 2, wherein component (B) is an acrylated epoxidised soybean oil or a polyacrylate or methacrylate obtained by the reaction of acrylic or methacrylic acid with a bis-phenol-based epoxy resin.

4. A method of coating a metal substrate, which comprises applying to the bare metal surface a coating composition as claimed in claim 1, 2 or 3, and exposing the coated substrate to radiation thereby to cure the coating composition.

5. A method according to claim 4, wherein the coating composition is cured by exposure to radiation having a wavelength of from $2000 \times 10^{-10}$m to $5000 \times 10^{-10}$m.

6. A method according to claim 4 or 5, wherein the coating is cured by exposure to electron beam radiation.

## Revendications

1. Composition de revêtement durcissable par irradiation pour substrats métalliques qui comprend un mélange de:

(A) 10 à 90 parties en poids par rapport aux poids combinés de (A) et (B) d'au moins un ester acrylique ou méthacrylique choisi parmi les suivants: acrylate d'isobornyle, acrylate de 2-éthylhexyle, acrylate d'éthoxyéthoxyéthyle, acrylate de dicyclopenténylоxyéthyle et méthacrylate de dicyclopenténylоxyéthyle;

(B) 10 à 90 parties en poids par rapport aux poids combinés de (A) et (B) d'au moins un produit de condensation ou d'addition oligomère acrylé qui contient au moins deux radicaux acryloxy de formule $H_2C{=}C(R)COO—$ où R représente H ou $CH_3$; et

(C) éventuellement un photosensibilisateur et/ou un accélérateur de type amine;

caractérisée en ce qu'elle contient de plus:

(D) 1 à 15% en poids par rapport aux poids combinés des composants (A) et (B) d'acide 3-acryloxypropionique.

2. Composition selon la revendication 1, caractérisée en ce qu'elle est un composition à 100% de matières sèches constituée des composants (A), (B) et (D) et éventuellement (C).

3. Composition selon l'une des revendications 1 ou 2, caractérisée en ce que le composant (B) est une huile de soja époxydée acrylée ou un polyacrylate ou méthacrylate obtenu par réaction de l'acide acrylique ou méthacrylique avec une résine époxyde à base de bisphénol.

4. Procédé pour revêtir un substrat métallique caractérisé en ce qu'il comprend l'application à la surface nu du métal d'une composition de revêtement selon l'une quelconque des revendications 1, 2 ou 3 et l'exposition du substrat revêtu à un rayonnement pour durcir la composition de revêtement.

5. Procédé selon la revendication 4, caractérisé en ce que la composition de revêtement est durcie par exposition à un rayonnement ayant une longueur d'onde de $2\,000 \times 10^{-10}$m à $5\,000 \times 10^{-10}$m.

6. Procédé selon l'une des revendications 4 ou 5, caractérisé en ce qu'on durcit le revêtement par exposition à un faisceau d'électrons.

**Patentansprüche**

1. Durch Strahlung härtbare Beschichtungsmasse für Metallsubstrate aus einer Mischung aus

(A) 10 bis 90 Gew.-Teilen, bezogen auf die Gesamtgewichte an (A) und (B), wenigstens eines Acrylat- oder Methacrylatesters, ausgewählt aus Isobornylacrylat, 2-Ethylhexylacrylat, Ethoxyethoxyethylacrylat, Dicyclopentenyloxyethylacrylat sowie Dicyclopentenyloxyethylmethacrylat,

(B) 10 bis 90 Gew.-Teilen, bezogen auf die Gesamtgewichte an (A) und (B), wenigstens eines acrylierten oligomeren Kondensations- oder Additionsproduktes, das wenigstens zwei Acryloxygruppen der Formel $H_2C{=}C(R)COO-$, worin R für H oder $CH_3$ steht, enthält, und

(C) gegebenenfalls einem Fotosensibilisator und/oder einem Aminbeschleuniger, dadurch gekennzeichnet, daß die Masse zusätzlich

(D) 1 bis 15 Gew.-%, bezogen auf das Gesamtgewicht aus den Komponenten (A) und (B), 3-Acryloxypropionsäure enthält.

2. Masse nach Anspruch 1, dadurch gekennzeichnet, daß sie eine zu 100% aus Feststoffen bestehende Masse ist, die aus den Komponenten (A), (B), (D) und gegebenenfalls (C) besteht.

3. Masse nach Anspruch 1 oder 2, dadurch gekennzeichnet, daß die Komponente (B) ein acryliertes epoxidiertes Sojabohnenöl oder ein Polyacrylat oder -methacrylat ist, das durch Umsetzung von Acrylsäure oder Methacrylsäure mit einem Epoxyharz auf der Basis von bis-Phenol hergestellt worden ist.

4. Verfahren zum Beschichten eines Metallsubstrats, dadurch gekennzeichnet, daß auf die blanke Metalloberfläche eine Beschichtungsmasse gemäß Anspruch 1, 2 oder 3 aufgebracht und das beschichtete Substrat zur Härtung der Beschichtungsmasse bestrahlt wird.

5. Verfahren nach Anspruch 4, dadurch gekennzeichnet, daß die Beschichtungsmasse durch Einwirkenlassen einer Strahlung mit einer Wellenlänge von $2000 \times 10^{-10}$ bis $5000 \times 10^{-10}$ m gehärtet wird.

6. Verfahren nach Anspruch 4 oder 5, dadurch gekennzeichnet, daß die Beschichtung mittels eines Elektronenstrahls gehärtet wird.